# EUROPEAN PATENT APPLICATION

(11) **EP 2 456 035 A1**
(43) Date of publication of application: **23.05.2012**
(21) Application number: 10192244.1
(22) Date of filing: 23.11.2010
(51) Int. Cl.: H02H 3/24, H01L 31/02

(54) **Controller, power inverter, photovoltaic power supply system, and method for controlling deactivation of at least one photovoltaic module**

(71) Applicant: SolarWorld Innovations GmbH, 09599 Freiberg/Sachsen (DE)
(72) Inventor: Georgi, Matthias, 01307, Dresden (DE); Storbeck, Olaf, 01109, Dresden (DE); Hahn, Harald, 01067, Dresden (DE); Kutzer, Martin, 09322, Penig (DE)
(74) Representative: Viering, Jentschura & Partner

(57) **Abstract**

A controller (114) for photovoltaic power supply may be configured to be connected with one or more photovoltaic modules (102) and configured to be connected with an AC grid terminal (108) for grid power supply additional to the photovoltaic power supply. The controller (114) may be configured to monitor the status of the AC power at the AC grid terminal (108) and to generate a signal for deactivation of the photovoltaic modules (102) if the AC power is off.

## Description

### Technical Field

Various embodiments relate generally to a controller, a power inverter, a photovoltaic power supply system, and a method for controlling deactivation of at least one photovoltaic module.

### Background

Various embodiments relate to photovoltaic arrangements, which are installed on or at a building, which have a connection to the public electric power supply (AC grid terminal).

Conventional photovoltaic arrangements have one or more power inverters for converting and possibly feeding the energy generated by the photovoltaic modules into the public energy supply network (e.g. 230 V_{AC} alternating current). As an alternative, the energy generated by the photovoltaic modules may completely or partially be consumed inside the building (own consumption) and may not be fed into the public energy supply network.

In the case of fire, the fire brigade usually switches off the energy supply into the building at an AC grid terminal being externally accessible (house connection box). However, the photovoltaic modules continue to provide energy during the day.

A power inverter may detect the disconnection from the energy supply network and may stop the network feeding, but the photovoltaic modules continue to supply open loop voltage during daylight. Therefore, it is possible that a dangerous voltage (up to 1000 V_{DC} direct current) may exist between the photovoltaic modules, which would endanger fireman at work and therefore hinder or prevent the fire quenching and recovery works in the case of fire.

There are various conventional approaches which try to address this situation:

- The energy supply of a complete photovoltaic module generator field at the introduction point into the building may be stopped or limited (as disclosed in DE 10 2005 018173 B4); in this approach, a dangerous voltage outside the building is not avoided.

- Thermal fuses or protections may be installed into the connection lines between the photovoltaic modules (as disclosed in DE 20 2006 007613 U1); in this approach, a simultaneous and forced effect for the entire generator field is not guaranteed and a dangerous voltage outside the building is not avoided.

- Switching elements may be integrated into the connection boxes of photovoltaic modules, which limit the energy supply of all photovoltaic modules at the same time in the case of fire, and thereby avoid a dangerous voltage (as disclosed in DE 10 2006 0608015 A1).

- The signal transmission may be carried out via the DC connection lines or via a separate signal line or via radio in a modulated manner (as disclosed in DE 10 2008 003272 A1).

- Another conventional approach may be to manually switch off photovoltaic modules for the purpose of installation and maintenance using a control signal (as disclosed in WO 2004/107543 A2).

In the case of fire, in the conventional approaches, it may not be possible to quickly detect:

a) as to whether the photovoltaic modules in the respective photovoltaic arrangement can the switched off or not; and

b) where the switch for switching off the photovoltaic modules can be found; and

c) as to whether a deactivation signal has been triggered.

d) Furthermore, the switch may no longer be accessible in the case of fire, if arranged inside the building, e.g. if included in or nearby of the power inverter.

### Summary

Various embodiments may provide a controller for photovoltaic power supply, configured to be connected with one or more photovoltaic modules and configured to be connected with an AC grid terminal, e.g. for grid power supply additional to the photovoltaic power supply, wherein the controller may be configured to monitor the status of the AC grid power and to generate a signal for deactivation of the photovoltaic modules if the AC power is off.

### Brief Description of the Drawings

In the drawings, like reference characters generally refer to the same or similar parts throughout the different views. The drawings are not necessarily to scale, emphasis instead generally being placed upon illustrating the principles of the invention. In the following description, various embodiments of the invention are described with reference to the following drawings, in which:
FIG. 1 shows a photovoltaic arrangement in accordance with various embodiments;
FIG. 2 shows a photovoltaic arrangement in accordance with various embodiments;
FIG. 3 shows a photovoltaic arrangement in accordance with various embodiments;
FIG. 4 shows a photovoltaic arrangement in accordance with various embodiments; and
FIG. 5 shows a flow diagram illustrating a method for controlling deactivation of at least one photovoltaic module in accordance with various embodiments.

### Detailed Description

The following detailed description refers to the accompanying drawings that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

Various embodiments provide an automatic generation of a control signal for switching off or deactivating photovoltaic modules.

Various embodiments may provide that the searching and the manual operation of a switch for deactivating the photovoltaic modules may be avoided. This may result in a gain of time when starting recovery measures in the case of fire. The automatic deactivation may also avoid risks from possible human failure in an emergency situation (it may not be thought about a switch for deactivating of the photovoltaic modules or the switch cannot be found).

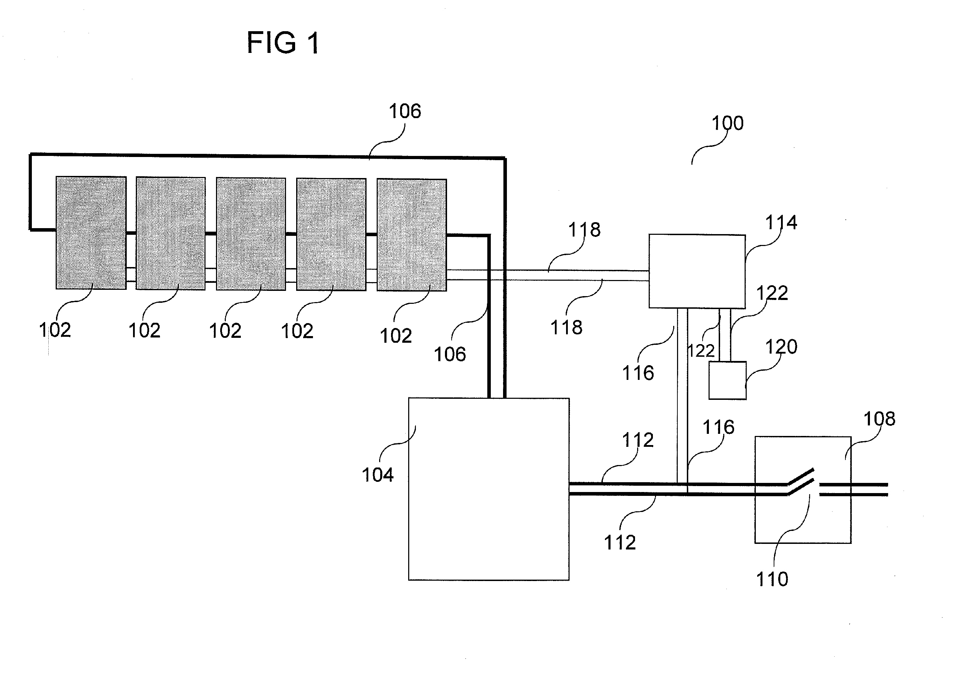

FIG. 1 shows a photovoltaic arrangement 100 in accordance with various embodiments with a separate controller 114, as will be described in more detail below.

In various embodiments, the photovoltaic arrangement 100 may include a plurality of photovoltaic modules 102. Each photovoltaic module 102 may include a plurality of photovoltaic cells. Each photovoltaic module 102 (e.g. a solar module 102) may be provided by electrically serially connecting a plurality of photovoltaic cells (e.g. solar cells) to obtain a photovoltaic cell string and sealing the photovoltaic cell string e.g. by a covering material into a module form. In various embodiments, the photovoltaic modules 102 may be connected with each outher in series and/or in parallel. In various embodiments, an arbitrary number of photovoltaic modules 102 may be in the photovoltaic arrangement 100. In various embodiments, each photovoltaic module 102 may generate a DC current and a DC voltage. In various embodiments, the photovoltaic modules 102 may be connected with each other as well as to one or more input terminals of a power inverter 104 via one or more DC (direct current) lines 106.

The power inverter 104 may be configured to convert the DC voltage and DC current (which it receives from the photovoltaic modules 102 via the two or more DC lines 106) into AC (alternating current) voltage and AC current, respectively, e.g. the AC current and AC voltage required by the (e.g. public) energy supply network or by the building or entity consuming the AC current and AC voltage. In various embodiments, two or more output terminals of the power inverter 104 may be connected to two or more connection points of an AC grid terminal 108 via two or more AC lines 112. The AC grid terminal 108 may include one or more switches 110, e.g. two or more power switches 110.

Power inverters 104 designed for feeding electric energy into public electric power grid (AC grid) need to synchronize with AC grid frequency. Therefore the AC grid lines will be sensed by the power inverter and the feed of electric energy will be stopped in case of AC power off.

Furthermore, in various embodiments, a controller 114 may be connected in parallel with the power inverter 104. In various embodiments, input terminals of the controller 114 may be connected to the two or more AC lines 112 via one or more AC tapping lines 116. The controller 114 and its configuration will be described in more detail below. In various embodiments, one or more output terminals of the controller 114 may be coupled to one or more photovoltaic modules 102 of the plurality of photovoltaic modules 102 or to switches (not shown in the figures) inserted between respective two photovoltaic modules 102 of the plurality of photovoltaic modules 102, e.g. via control signal lines 118.

The controller 114 may be implemented in various ways, such as e.g. as a hard-wired controller or as a programmable controller. In various embodiments, the controller 114 may be implemented using one or more field programmable gate arrays (FPGA). The programmable controller may be implemented using any kind of programmable logic such as e.g. a microcontroller (e.g. a reduced instruction set computer (RISC) microcontroller or a complex instruction set computer (CISC) microcontroller). In various embodiments, any type of logic or circuitry which may be configured to implement the functionality of the controller 114 as described below may be an implementation of the controller 114.

Optionally, the photovoltaic arrangement 100 may further include signal indicator device 120, which may be coupled to optional additional output terminals of the controller 114 via one or more additional control signal lines 122.

Thus, in various embodiments, the controller 114 may be configured to be connected with one or more photovoltaic modules 102 and configured to be connected with the AC grid terminal 108 for grid power supply additional to the photovoltaic power supply. The controller 114 may be configured to monitor the status of the AC power at the AC grid terminal 108 (which may be monitored via the one or more AC tapping lines 116) and to generate a signal for deactivation of the photovoltaic modules 102 (e.g. via the one or more control signal lines 118), if it is determined by the controller 114 that the AC power is off. The controller 114 may be configured to generate the signal for deactivation of the photovoltaic modules 102 as one time signal. As an alternative, the controller 114 may be configured to generate the signal for deactivation of the photovoltaic modules 102 permanently as long as the AC power is (determined to be) off.

Illustratively, in case the AC grid terminal (e.g. the AC grid terminal 108) is switched off or deactivated (e.g. in case of a dangerous situation), the controller 114 detects this deactivation and, in response to this detection, generates a deactivation signal for the photovoltaic modules 102 and transmits them into the photovoltaic module 102 array. Thus, in various embodiments, the photovoltaic modules 102 are automatically deactivated.

The deactivation may result in that the connections between the photovoltaic modules 102 of the plurality of photovoltaic modules 102 (which may also be referred to as photovoltaic module array) are interrupted or that the photovoltaic modules 102 are short circuited. This has the effect that no dangerous voltage exist within the photovoltaic arrangement 100.

In various embodiments, an active deactivation signal may be represented by means of a positive (or negative) signal voltage level, in other words, a non-zero signal voltage level. As an alternative, it may also be provided (e.g. for reasons of error reliability or as fault safe system) that an inactive deactivation signal is represented by means of a positive (or negative) signal voltage level, in other words, a non-zero signal voltage level, which is not applied in the case of activation (illustratively, this may also be referred to as an inverse deactivation signal).

In addition to the automatic photovoltaic module deactivation, a manual switch may be provided, which may be operated in the case of installation, maintenance and repair at or of the photovoltaic arrangement.

In various embodiments, the deactivation signal may be transmitted from the controller to the photovoltaic module array electrically, optically or via radio signals.

It is to be mentioned that the various implementations of the functions of the controller 114 as described above may similarly provided in the various embodiments which will be described in more detail below.

Illustratively, FIG.1 shows a photovoltaic arrangement 100 having a separate controller 114, which is connect in parallel to the power inverter 104 and wherein one or more separate control signal lines are provided. The controller 114 is independent from the type of the power inverter 104 used and independent from as to whether the photovoltaic arrangement 100 does provide energy into the public energy supply network at all and/or as to whether the energy generated by the photovoltaic modules 102 is consumed locally, e.g. in the building at or on which the photovoltaic arrangement 100 is mounted.

In various embodiments, the search for and the manual operation of a switch for deactivation of the photovoltaic modules is avoided and this may result in a gain of time in starting recovery measures (e.g. in the case of fire).

Furthermore, the automatic deactivation may avoid risks due to possible human failure in emergency situations (e.g. it may not be thought about the switch for the deactivation of the photovoltaic modules or the switch for the deactivation of the photovoltaic modules may not be found).

In various embodiments, the signal indicator device 120 may also be integrated into the controller 114 or into the controllers of the embodiments which will be described below in more detail. In various embodiments, the signal indicator device 120 may also be arranged in the neighborhood of the controller 114 or in an exterior region of the builing. In various embodiments, the signal indicator device 120 may indicate that the respective photovoltaic arrangement 100 includes deactivatable photovoltaic modules 102 by means of its configuration (size, color, shape, etc.).

A second function of the signal indicator device 120 may further be to convert the deactivation signal such that the converted deactivation signal can be detected from outside of the photovoltaic arrangement 100. In various embodiments, the signal indicator device 120 may be arranged or mounted outside the photovoltaic arrangement 100 and outside the building. This may ensure the noticeability and funtionality of the signal indicator device 120 in the case of fire.

By way of example, the deactivation signal may be converted into an optical signal by means of the signal indicator device 120, e.g. into a continuous light signal or into a blinking light signal or into a regular flashlight signal.

The deactivation signal may also be converted into a radio signal by means of the signal indicator device 120, which may use a radio frequency which may be provided or reserved for such an emergency signal. A rescue team having a receiver being adjusted to this specfic frequency may thus be made aware of the deactivation signal.

In various embodiments, the signal indicator device 120 may receive its operation energy from the deactivation signal itself, if the deactivation signal has a positive voltage level (e.g. a voltage > 0 V) in case of deactivation.

In various embodiments, the signal indicator device 120 may receive its operation energy from a single photovoltaic module 102 (or a plurality, but nor all photovoltaic modules 102, e.g. from a single photovoltaic module string). This may e.g. be provided in case the deactivation signal is an inverse deactivation signal, i.e. the positive signal level does not exist in case of the deactivation.

In various embodiments, the signal indicator device 120 may receive its operation energy from an energy storage (e.g. a battery or an accumulator) being integrated into the signal indicator device 120, which may be re-loaded in the case of normal operation of the photovoltaic arrangement 100.

In various embodiments, the signal indicator device 120 may indicate that the photovoltaic arrangement 100 does not provide any dangerous voltage. This may result in a security gain for the rescue team or makes rescure measures possible at all.

In various embodiments, the signal indicator 120 may be configured to indicate the deactivation signal by means of a signal such as e.g. an optical deactivation indication signal; and/or a radio deactivation indication signal; and/or an electrical wireline deactivation indication signal.

In various embodiments, the photovoltaic arrangement 100, e.g. the controller 114, may include a transmitter (not shown in FIG.1), which may be configured to transmit the deactivation signal into the photovoltaic module array. In various embodiments, the transmitter may be configured to transmit the deactivation signal e.g. to at least one photovoltaic module as an optical signal and/or as a radio signal and/or as an electrical signal.

Furthermore, the AC grid terminal 108 may be connected downstream to the (e.g. public) energy supply network, to thereby feed electrical energy, such as AC voltage and AC current, which is generated by the photovoltaic modules 102 and converted by the power inverter 104, into the (e.g. public) energy supply network.

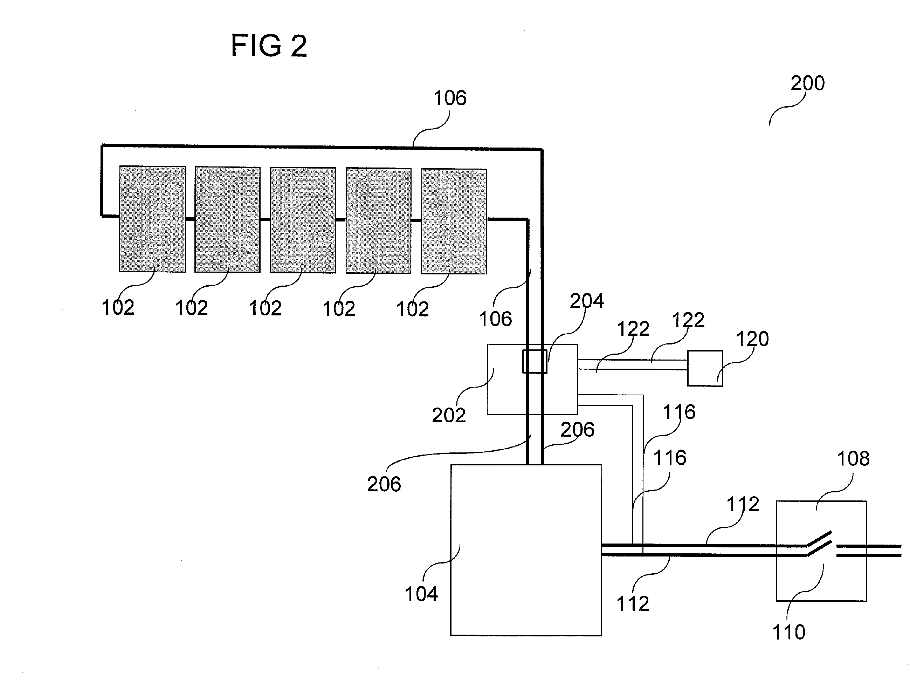

FIG. 2 shows a photovoltaic arrangement 200 in accordance with various embodiments. The photovoltaic arrangement 200 of FIG. 2 is substantially similar to the photovoltaic arrangement 100 of FIG.1. Therefore, only the differences of the photovoltaic arrangement 200 of FIG. 2 compared with the photovoltaic arrangement 100 of FIG. 1 will be described in more detail below.

In the photovoltaic arrangement 200 of FIG. 2, the controller 202 is still a device separate from the power inverter 104, but is connected within the DC signal path between the photovoltaic modules 102 and the power inverter 104. In other words, one or more terminals of the controller 202 are coupled with the one or more DC lines 106 coming from the photovoltaic modules 102. Furthermore, additional one or more DC lines 206 may be provided which is/are coupled between one or more terminals of the controller 202 and one or more input terminals of the power inverter 104. The configuration of the controller 202 is similar to the configuration of the controller 114 of FIG. 1, wherein the controller 202 additionally includes a transmitter 204 (it is to be noted that the control signal lines 118 of the photovoltaic arrangement 100 of FIG. 1 are omitted in the photovoltaic arrangement 200 of FIG. 2). The transmitter 204 may be configured to modulate (e.g. using amplitude modulation and/or frequency modulation and/or phase modulation, etc.) the deactivation signal onto the one or more DC lines 106 to thereby transmit the same to the photovoltaic module array via the one or more DC lines 106, e.g. using a kind of powerline technology.

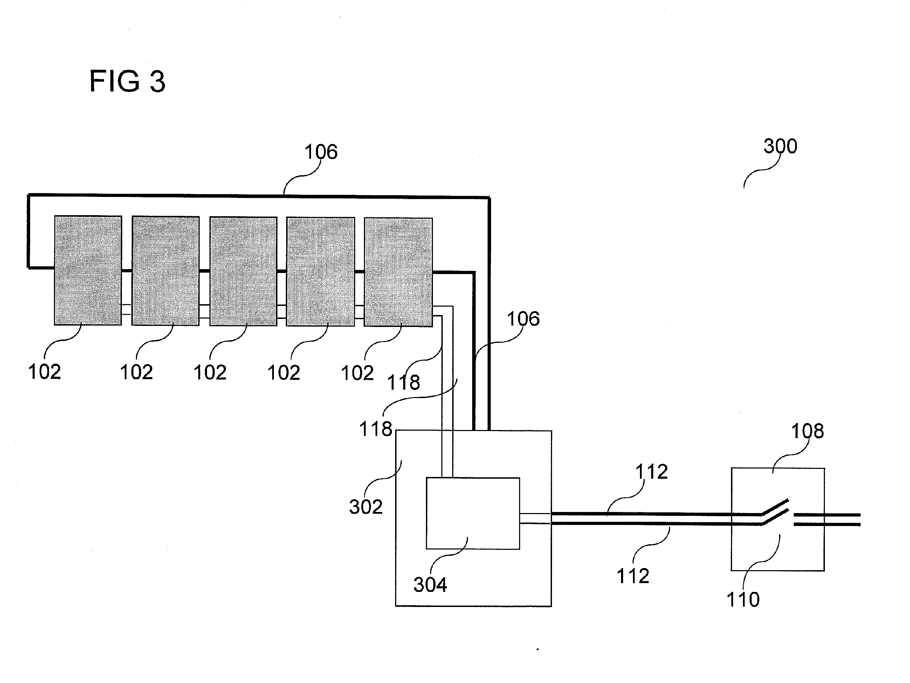

FIG. 3 shows a photovoltaic arrangement 300 in accordance with various embodiments. The photovoltaic arrangement 300 of FIG. 3 is substantially similar to the photovoltaic arrangement 100 of FIG. 1. Therefore, only the differences of the photovoltaic arrangement 300 of FIG. 3 compared with the photovoltaic arrangement 100 of FIG.1 will be described in more detail below.

In the photovoltaic arrangement 300 of FIG. 3, the controller 304 may be integrated (i.e. e.g. accomodated in the same housing, e.g. even implemented on the same printed circuit board) in the power inverter 302. Furthermore, in these embodiments, one or more separate control signal lines 118 may be provided for transmitting the deactivation signal from the controller 304 to the at least one photovoltaic module, in general to the photovoltaic module array.

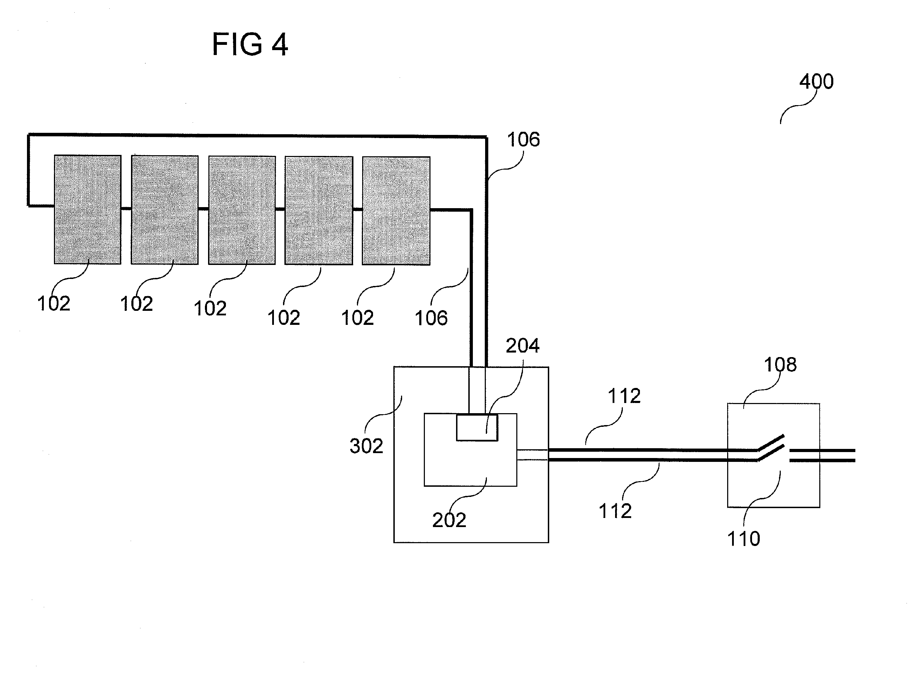

FIG. 4 shows a photovoltaic arrangement 400 in accordance with various embodiments. Illustratively, the photovoltaic arrangement 400 of FIG. 4 is a combination of the photovoltaic arrangement 200 of FIG. 2 and the photovoltaic arrangement 300 of FIG. 3. In more detail, the photovoltaic arrangement 400 of FIG. 4 includes the controller 202 and the transmitter 204 as described with reference to FIG. 2, wherein the controller 202 is integrated into the power inverter 302, as described with reference to FIG. 3.

In various embodiments, the controller, such as the controllers 114, 202, 304, 404, is further configured to monitor one or more DC power lines of one or more photovoltaic modules for electric arc detection and to generate a signal for deactivation of the photovoltaic modules in case of electric arc detection.

In various embodiments, a controller for a photovoltaic arrangement is provided, which is connected to the AC grid terminal for the photovoltaic arrangement. The controller may be part of the power inverter (e.g. integrated in the same housing) of the photovoltaic arrangement or may be a separate device, which may be connected in parallel to the power inverter.

In various embodiments, the automatic deactivation of the photovoltaic modules at a deactivated network terminal (e.g. at a deactivated AC grid terminal 108) may result in that the photovoltaic arrangement 100, 200, 300, 400 may also be deactivated in the case of a power failure within the public energy supply network.

In additional option in accordance with various embodiments may be to integrate into the controller a circuit configured to detect electric light arcs occurring within the photovoltaic arrangement 100, 200, 300, 400. Electric light arcs may occurr at open contact points in the DC circuitry and may easily cause fire due to the associated high temperatures. In various embodiments, the circuit configured to detect electric light arcs may be configured to detect the arcs using high-frequency signal portions existing on the one or more DC lines 106. As soon as the controller detects such high-frequency signal portions, the deactivation signal may be generated or triggered. This may result in an increased operation security and increased security against fire.

Another option of various embodiments, may be that the is further configured to monitor one or more DC power lines of one or more photovoltaic modules for fault current detection and to generate a signal for deactivation of the photovoltaic modules in case of fault current detection. In various embodiments, fault currents may be caused due to an inadequate isolation and may occurr between the one or more DC lines 106, one or more separate electrical signal lines (such as e.g. the one or more control signal lines 118) and the grounding equipment conductor potential (module frame and support frame).
The deactivation signal may be generated or triggered in case of detection of the fault current. This may further increase the operation security.

In various embodiments, the photovoltaic arrangement 100, 200, 300, 400 and thus the photovoltaic power supply system may further include a radiation sensor and/or a wind meter. In this case, the signal indicator 120 and the radiation sensor and/or the wind meter may be accommodated in a common housing.

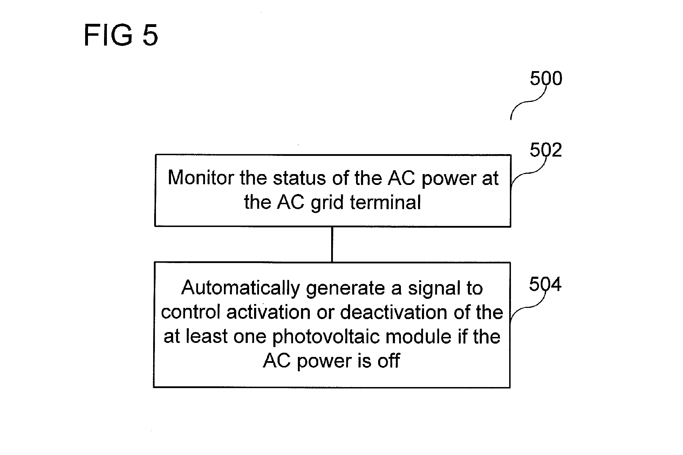

FIG. 5 shows a flow diagram 500 illustrating a method for controlling deactivation of at least one photovoltaic module in accordance with various embodiments. In various embodiments, the method may include, in 502, monitoring the status of the AC power at the AC grid terminal, and, in 504, automatically generating a signal to control activation or deactivation of the at least one photovoltaic module if the AC power is off. In various embodiments, the method may further include monitoring one or more DC power lines of photovoltaic modules for electric arc detection and to generate a signal for deactivation of the photovoltaic modules in case of electric arc detection. In various embodiments, the method may further include monitoring one or more DC power lines of photovoltaic modules for fault current detection and to generate a signal for deactivation of the photovoltaic modules in case of fault current detection.

While the invention has been particularly shown and described with reference to specific embodiments, it should be understood by those skilled in the art that various changes in form and detail may be made therein without departing from the spirit and scope of the invention as defined by the appended claims. The scope of the invention is thus indicated by the appended claims and all changes which come within the meaning and range of equivalency of the claims are therefore intended to be embraced.

## Claims

1. A controller for photovoltaic power supply, configured to be connected with one or more photovoltaic modules and configured to be connected with an AC grid terminal, wherein the controller is configured to monitor the status of the AC grid power and to generate a signal for deactivation of the photovoltaic modules if the AC power is off.

2. The controller of claim 1,
wherein the controller is further configured to monitor one or more DC power lines of one or more photovoltaic modules for electric arc detection and to generate a signal for deactivation of the photovoltaic modules in case of electric arc detection.

3. The controller of any one of claims 1 or 2,
wherein the controller is further configured to monitor one or more DC power lines of one or more photovoltaic modules for fault current detection and to generate a signal for deactivation of the photovoltaic modules in case of fault current detection.

4. The controller of any one of claims 1 to 3, further comprising:
a transmitter configured to transmit the signal for deactivation to the at least one photovoltaic module as an optical signal and/or as a radio signal and/or as an electrical signal.

5. The controller of any one of claims 1 to 4,
wherein the controller is further configured to generate the signal such that it controls the activation of the at least one photovoltaic module with an active signal and such that it controls the deactivation of the at least one photovoltaic module with an inactive signal.

6. The controller of any one of claims 1 to 4,
wherein the controller is configured to generate the signal such that it controls the activation of the at least one photovoltaic module with an inactive signal and such that it controls the deactivation of the at least one photovoltaic module with an active signal.

7. A power inverter for photovoltaic modules comprising a controller of any one of claims 1 to 6.

8. A photovoltaic power supply system, comprising:
at least one photovoltaic module;
a power inverter; and
a controller of any one of claims 1 to 6, wherein the controller is coupled to the at least one photovoltaic module.

9. The photovoltaic power supply system of claim 8,
wherein the controller is separated from the power inverter and connected in parallel to the power inverter.

10. The photovoltaic power supply system of claim 8, wherein
the controller is included in the power inverter.

11. The photovoltaic power supply system of any one of claims 8 to 10, further comprising:
a signal indicator configured to indicate the occurrence of deactivation signal for the at least one photovoltaic module.

12. The photovoltaic power supply system of claim 11,
wherein the signal indicator is configured to indicate the deactivation signal by means of a signal selected from a group of signals consisting of:
an optical deactivation indication signal;
a radio deactivation indication signal; and
a electrical wireline deactivation indication signal.

13. The photovoltaic power supply system of any one of claims 11 to 12, further comprising:
a radiation sensor and/or a wind meter;
wherein the signal indicator and the radiation sensor and/or the wind meter are accommodated in a common housing.

14. A method for controlling deactivation of at least one photovoltaic module, the method comprising:
monitoring the status of the AC power at the AC grid terminal ;
automatically generating a signal to control deactivation of the at least one photovoltaic module if the AC power is off.

15. The method of claim 14, further comprising:
monitoring one or more DC power lines of photovoltaic modules for electric arc detection and to generate a signal for deactivation of the photovoltaic modules in case of electric arc detection.

16. The method of any one of claims 14 or 15, further comprising:
monitoring one or more DC power lines of photovoltaic modules for fault current detection and to generate a signal for deactivation of the photovoltaic modules in case of fault current detection.
